# EUROPÄISCHE PATENTSCHRIFT

(11) **EP 3 769 409 B1**
(45) Veröffentlichungstag und Bekanntmachung des Hinweises auf die Patenterteilung: **19.02.2025**
(21) Anmeldenummer: 19727861.7
(22) Anmeldetag: 15.05.2019
(51) Int. Cl.: H02M 1/08, H02M 3/158, H03K 17/082, H03K 17/16, H02M 1/00

(54) **ANSTEUERN EINES METALL-OXID-HALBLEITER-FELDEFFEKTTRANSISTORS**
CONTROL OF A METAL OXIDE SEMICONDUCTOR FIELD EFFECT TRANSISTOR
COMMANDE D'UN TRANSISTOR MÉTAL-OXYDE-SEMICONDUCTEUR À EFFET DE CHAMP

(30) Priorität: 29.05.2018 EP 18174802
(43) Veröffentlichungstag der Anmeldung: 27.01.2021
(73) Patentinhaber: Siemens Aktiengesellschaft, 80333 München (DE)
(72) Erfinder: BAKRAN, Mark-Matthias, 91052 Erlangen (DE); BÖHMER, Jürgen, 90547 Stein (DE); HELSPER, Martin, 90584 Allersberg (DE); KRAFFT, Eberhard Ulrich, 90419 Nürnberg (DE); LASKA, Bernd, 91074 Herzogenaurach (DE); NAGEL, Andreas, 90431 Nürnberg (DE); SCHÖNEWOLF, Stefan Hans Werner, 90489 Nürnberg (DE); WEIGEL, Jan, 91077 Großenbuch (DE)
(74) Vertreter: Siemens Patent Attorneys
(86) Internationale Anmeldenummer: PCT/EP2019/062457
(87) Internationale Veröffentlichungsnummer: WO 2019/228808

(56) Entgegenhaltungen:
- DE-T5- 112016 002 958
- DE-T5- 112016 002 958
- INSTRUMENTS TEXAS: "UCD7138 4-A and 6-A Single-Channel Synchronous-Rectifier Driver With Body-Diode Conduction Sensing and Reporting", 31 May 2015 (2015-05-31), XP055524770, Retrieved from the Internet <URL:http://www.ti.com/lit/ds/symlink/ucd7138.pdf> [retrieved on 20181119]
- HELEN DING: "IR1161 [mu]SmartRectifier(TM) Control IC", 23 July 2015 (2015-07-23), pages 2015 - 7, XP055524762, Retrieved from the Internet <URL:https://www.infineon.com/dgdl/an_201507_pl16_011.pdf?fileId=5546d462533600a4015355907db10f27> [retrieved on 20181119]
- AKIMASA NIWA ET AL: "A Dead-Time-Controlled Gate Driver Using Current-Sense FET Integrated in SiC MOSFET", IEEE TRANSACTIONS ON POWER ELECTRONICS, vol. 33, no. 4, 1 April 2018 (2018-04-01), USA, pages 3258 - 3267, XP055524760, ISSN: 0885-8993, DOI: 10.1109/TPEL.2017.2704620
- NIWA AKIMASA ET AL: "Novel dead time controlled gate driver using the current sensor of SiC-MOSFET", IECON 2015 - 41ST ANNUAL CONFERENCE OF THE IEEE INDUSTRIAL ELECTRONICS SOCIETY, IEEE, 9 November 2015 (2015-11-09), pages 1651 - 1656, XP032855493, DOI: 10.1109/IECON.2015.7392338
- HELEN DING: "IR11688 Smart Rectifier(TM) Control IC Design Notes", 31 July 2015 (2015-07-31), pages 1 - 35, XP055715572, Retrieved from the Internet <URL:https://www.infineon.com/dgdl/Infineon-ApplicationNote-IR11688-SmartRectifier-Control-IC-DesignNotes-AN-v01_00-EN.pdf?fileId=5546d46253f65057015418afca1d4d20> [retrieved on 20200716]
- INFINEON TECHNOLOGIES AG: "Smartrectifier IR11688S DUAL SYNCHRONOUS RECTIFICATION CONTROL IC", 17 May 2017 (2017-05-17), XP093022799, Retrieved from the Internet <URL:https://www.infineon.com/dgdl/ir11688spbf.pdf?fileId=5546d462533600a4015355c47c70165c> [retrieved on 20230210]
- INSTRUMENTS TEXAS: "UCD7138 4-A and 6-A Single-Channel Synchronous-Rectifier Driver With Body-Diode Conduction Sensing and Reporting", 31 May 2015 (2015-05-31), XP055524770, Retrieved from the Internet <URL:http://www.ti.com/lit/ds/symlink/ucd7138.pdf> [retrieved on 20181119]
- HELEN DING: "IR1161 [mu]SmartRectifier(TM) Control IC", 23 July 2015 (2015-07-23), pages 2015 - 7, XP055524762, Retrieved from the Internet <URL:https://www.infineon.com/dgdl/an_201507_pl16_011.pdf?fileId=5546d462533600a4015355907db10f27> [retrieved on 20181119]
- AKIMASA NIWA ET AL: "A Dead-Time-Controlled Gate Driver Using Current-Sense FET Integrated in SiC MOSFET", IEEE TRANSACTIONS ON POWER ELECTRONICS, vol. 33, no. 4, 30 April 2018 (2018-04-30), USA, pages 3258 - 3267, XP055524760, ISSN: 0885-8993, DOI: 10.1109/TPEL.2017.2704620
- NIWA AKIMASA ET AL: "Novel dead time controlled gate driver using the current sensor of SiC-MOSFET", IECON 2015 - 41ST ANNUAL CONFERENCE OF THE IEEE INDUSTRIAL ELECTRONICS SOCIETY, IEEE, 9 November 2015 (2015-11-09), pages 1651 - 1656, XP032855493, DOI: 10.1109/IECON.2015.7392338

## Beschreibung

Die Erfindung betrifft ein Verfahren und eine Ansteueranordnung zum Ansteuern eines Metall-Oxid-Halbleiter-Feldeffekttransistors (MOSFET = Metal-Oxide-Semiconductor Field-Effect Transistor), insbesondere eines auf einem Halbleiter mit breitem Bandabstand (Wide-Bandgap Semiconductor) basierenden MOSFET.

Ein MOSFET ist rückwärts leitfähig und weist einen p-n-Übergang zwischen Bulk und Drain auf, der bei elektrischer Verbindung von Bulk und Source als eine intrinsische Diode wirkt, die als Inversdiode oder als Bodydiode des MOSFET bezeichnet wird. Rückwärtsströme fließen durch die Bodydiode, wenn der MOSFET ausgeschaltet ist. Da die Bodydiode einen hohen Widerstand aufweist, entstehen dabei hohe Verluste. Beträchtliche Verluste dieser Art können insbesondere in einem in MOSFET-Technologie ausgeführten Stromrichter auftreten, wenn in einem Fehlerfall alle MOSFET des Stromrichters ausgeschaltet werden und Rückwärtsströme aus einem mit dem Stromrichter verbundenen Vorsorgungsnetz oder einer mit dem Stromrichter verbundenen Last durch Bodydioden der MOSFET des Stromrichters fließen. Gegenwärtig werden in bestimmten Stromrichtern, beispielsweise in Traktionsstromrichtern, vermehrt MOSFET eingesetzt, die auf Halbleitern mit breitem Bandabstand, beispielsweise auf Siliciumcarbid oder Galliumnitrid, basieren und hohen Strombelastungen ausgesetzt sind. Insbesondere in diesen Stromrichtern entsteht daher das Problem, dass Rückwärtsströme durch die MOSFET bei einem fehlerbedingten Ausschalten aller MOSFET zu hohen Verlusten führen können.

Das Dokument Texas Instruments: "UCD7138 4-A and 6-A Single-Channel Synchronous-Rectifier Driver With Body-Diode Conduction Sensing and Reporting", 31. Mai 2015 (2015-05-31), URL: http://www.ti.com/lit/ds/symlink/ucd7138.pdf offenbart einen MOSFET-Treiber mit einem Gate-Treiber, einer Schaltung zum Erfassen eines Bodydiodenleitzustands und einer Schaltung zum Optimieren einer Einschaltverzögerung.

DE 11 2016 002 958 T2 offenbart ein Verfahren zum Steuern einer elektrischen Servolenkungsvorrichtung, die mehrere Wechselrichterbrücken umfasst, die jeweils mit einem Mehrphasenmotor verbunden sind, der zum Bereitstellen einer Leistungsunterstützung zur Lenkung eines Fahrzeugs konfiguriert ist. Das Verfahren umfasst nach einer Detektion eines Ausfalls innerhalb einer der Wechselrichterbrücken ein Steuern des Stromflusses innerhalb der fehlerhaften Wechselrichterbrücke und ein Verwenden einer oder mehrerer der anderen Wechselrichterbrücken, damit eine Leistungsunterstützung bereitgestellt wird.

Helen Ding: "IR11688 Smart Rectifier(TM) Control 1C Design Notes", 31. Juli 2015 (2015-07-31), Seiten 1-35, XP055715572, gefunden im Internet: URL:https://www.infineon.com/dgdl/lnfineon-ApplicationNote-1R11688-SmartRectifier-Control-1C-DesignNotes-AN-v01_00-EN.pdf fileld=5546d46253f65057015418afca1 d4d20 [gefunden am 2020-07-16] offenbart ein Verfahren zum Ansteuern eines MOSFET.

Der Erfindung liegt die Aufgabe zugrunde, ein Verfahren und eine Ansteueranordnung zum Ansteuern eines MOSFET anzugeben, die hinsichtlich der Reduzierung von durch Rückwärtsströme verursachten Verlusten verbessert sind.

Die Aufgabe wird erfindungsgemäß durch ein Verfahren mit den Merkmalen des Anspruchs 1 und eine Ansteueranordnung mit den Merkmalen des Anspruchs 5 gelöst.

Vorteilhafte Ausgestaltungen der Erfindung sind Gegenstand der Unteransprüche.

Das erfindungsgemäße Verfahren betrifft das Ansteuern eines MOSFET, insbesondere eines auf einem Halbleiter mit breitem Bandabstand basierenden MOSFET, mit einem Drain-Anschluss, einem Source-Anschluss, einem Gate-Anschluss und einer Body-diode, wobei der MOSFET in einem mehrere MOSFET aufweisenden Stromrichter angeordnet ist. Dabei wird nach dem Auftreten eines Fehlerfalls, der zu einem Ausschalten aller MOSFET des Stromrichters geführt hat, überwacht, ob die Bodydiode des MOSFET elektrisch leitend ist. Der MOSFET wird eingeschaltet, wenn die Bodydiode elektrisch leitend ist, und der MOSFET wird in Abhängigkeit von einem Ansteuersignal angesteuert, wenn die Bodydiode elektrisch sperrend ist.

Die Erfindung sieht also vor, nach dem Auftreten eines Fehlerfalls, der zu einem Ausschalten aller MOSFET des Stromrichters geführt hat, einen MOSFET einzuschalten, wenn seine Bodydiode leitend und somit stromführend ist. Durch das Einschalten des MOSFET werden Rückwärtsströme, die im ausgeschalteten Zustand des MOSFET allein durch die Bodydiode fließen würden, zumindest teilweise durch den MOSFET-Kanal zwischen dem Source-Anschluss und dem Drain-Anschluss geführt, so dass durch die Bodydiode fließende Rückwärtsströme und die dadurch verursachten Verluste stark reduziert werden. Wenn die Bodydiode elektrisch sperrend ist, wird der MOSFET wie üblich in Abhängigkeit von einem Ansteuersignal angesteuert, so dass die Ansteuerung des MOSFET in diesem Fall nicht geändert wird.

Die Erfindung sieht ferner vor, dass ein erster Spannungs-Schwellenwert für eine Drain-Source-Spannung zwischen dem Drain-Anschluss und dem Source-Anschluss des MOSFET vorgegeben wird, die Drain-Source-Spannung erfasst wird und darauf geschlossen wird, dass die Bodydiode elektrisch leitend ist, wenn die Drain-Source-Spannung den ersten Spannungs-Schwellenwert unterschreitet. Ferner wird ein zweiter Spannungs-Schwellenwert für die Drain-Source-Spannung vorgegeben und darauf geschlossen, dass die Bodydiode elektrisch sperrend ist, wenn die Drain-Source-Spannung den zweiten Spannungs-Schwellenwert überschreitet. Beispielsweise sind beide Spannungs-Schwellenwerte negativ und der zweite Spannungs-Schwellenwert ist größer als der erste Spannungs-Schwellenwert.

Die vorgenannten Aspekte der Erfindung nutzen die Drain-Source-Spannung, um zu erkennen, ob die Bodydiode des MOSFET elektrisch leitend oder sperrend ist. Dazu werden Spannungs-Schwellenwerte verwendet, deren Unter- beziehungsweise Überschreiten signalisieren, dass die Bodydiode elektrisch leitend beziehungsweise sperrend ist.

Eine Ausgestaltung der Erfindung sieht vor, dass ein erster Strom-Schwellenwert für eine Drain-Source-Stromstärke eines in einer Durchlassrichtung der Bodydiode zwischen dem Drain-Anschluss und dem Source-Anschluss des MOSFET fließenden Drain-Source-Stroms vorgegeben wird, die Drain-Source-Stromstärke erfasst wird und darauf geschlossen wird, dass die Bodydiode elektrisch leitend ist, wenn die Drain-Source-Stromstärke den ersten Strom-Schwellenwert überschreitet. Ferner kann ein zweiter Strom-Schwellenwert für die Drain-Source-Stromstärke, der kleiner als der erste Strom-Schwellenwert ist, vorgegeben werden und darauf geschlossen werden, dass die Bodydiode elektrisch sperrend ist, wenn die Drain-Source-Stromstärke den zweiten Strom-Schwellenwert unterschreitet.

Die Erfindung sieht vor, dass die Richtung eines zwischen dem Drain-Anschluss und dem Source-Anschluss des MOSFET fließenden Drain-Source-Stroms erfasst wird und darauf geschlossen wird, dass die Bodydiode elektrisch leitend ist, wenn der Drain-Source-Strom in einer Durchlassrichtung der Bodydiode fließt. Ferner kann darauf geschlossen werden, dass die Body-diode elektrisch sperrend ist, wenn der Drain-Source-Strom entgegengesetzt zu der Durchlassrichtung der Bodydiode fließt.

Die Erfindung nutzt dabei den Drain-Source-Strom, um zu erkennen, ob die Bodydiode elektrisch leitend oder sperrend ist. Dazu werden Strom-Schwellenwerte für die Stromstärke des Drain-Source-Stroms in der Durchlassrichtung der Bodydiode verwendet, deren Unter- beziehungsweise Überschreiten signalisieren, dass die Bodydiode elektrisch leitend beziehungsweise sperrend ist. Die Drain-Source-Stromstärke wird beispielsweise mit einem Shuntwiderstand gemessen, der in dem Strompfad des Drain-Source-Stroms angeordnet ist. Alternativ oder zusätzlich wird die Richtung des Drain-Source-Stroms erfasst, um zu erkennen, ob die Bodydiode elektrisch leitend oder sperrend ist. Die Richtung des Drain-Source-Stroms wird beispielsweise durch eine Zählung der ausgelösten Spannungsimpulse oder durch ein Flipflop, das bei jedem ausgelösten Spannungsimpuls seinen Zustand ändert, bestimmt.

Eine erfindungsgemäße Ansteueranordnung zur Durchführung des erfindungsgemäßen Verfahrens umfasst eine Überwachungseinheit, die dazu ausgebildet ist, zu ermitteln, ob die Bodydiode elektrisch leitend oder sperrend ist, und eine Steuereinheit, die dazu ausgebildet ist, nach dem Auftreten eines Fehlerfalls, der zu einem Ausschalten aller MOSFET des Stromrichters geführt hat, den MOSFET einzuschalten, wenn die Überwachungseinheit ermittelt, dass die Bodydiode elektrisch leitend ist, und den MOSFET in Abhängigkeit von dem Ansteuersignal anzusteuern, wenn die Bodydiode elektrisch sperrend ist.

Die Überwachungseinheit ist dazu ausgebildet, die Drain-Source-Spannung zu erfassen und anhand der Drain-Source-Spannung zu ermitteln, ob die Bodydiode elektrisch leitend oder sperrend ist. Ausgestaltungen der erfindungsgemäßen Ansteueranordnung sehen vor, dass die Überwachungseinheit dazu ausgebildet ist, die Drain-Source-Stromstärke zu erfassen und anhand der Drain-Source-Stromstärke zu ermitteln, ob die Bodydiode elektrisch leitend oder sperrend ist, oder/und dass die Überwachungseinheit dazu ausgebildet ist, die Richtung des Drain-Source-Stroms zu erfassen und anhand der Richtung des Drain-Source-Stroms zu ermitteln, ob die Bodydiode elektrisch leitend oder sperrend ist.

Eine weitere Ausgestaltung der erfindungsgemäßen Ansteueranordnung sieht vor, dass die Überwachungseinheit dazu ausgebildet ist, der Steuereinheit durch ein Zusatzansteuersignal mitzuteilen, ob die Bodydiode elektrisch leitend oder sperrend ist, und die Steuereinheit eine Endstufe zur Ansteuerung des MOSFET in Abhängigkeit von dem Zusatzansteuersignal und dem Ansteuersignal aufweist. Eine dazu alternative Ausgestaltung der erfindungsgemäßen Ansteueranordnung sieht vor, dass die Überwachungseinheit dazu ausgebildet ist, der Steuereinheit durch ein Zusatzansteuersignal mitzuteilen, ob die Body-diode elektrisch leitend oder sperrend ist, und die Steuereinheit eine erste Endstufe zur Ansteuerung des MOSFET in Abhängigkeit von dem Ansteuersignal im Fall, dass die Bodydiode elektrisch sperrend ist, und eine zweite Endstufe zur Ansteuerung des MOSFET in Abhängigkeit von dem Zusatzansteuersignal im Fall, dass die Bodydiode elektrisch leitend ist, aufweist.

Eine erfindungsgemäße Ansteueranordnung ermöglicht die Durchführung des erfindungsgemäßen Verfahrens. Die Vorteile einer erfindungsgemäßen Ansteueranordnung entsprechen daher den oben bereits genannten Vorteilen des erfindungsgemäßen Verfahrens und werden hier nicht noch einmal gesondert aufgeführt.

Insgesamt modifiziert die Erfindung die Ansteuerung eines MOSFET nur nach dem Auftreten eines Fehlerfalls, der zu einem Ausschalten aller MOSFET des Stromrichters geführt hat, in dem Fall, dass die Bodydiode elektrisch leitend ist. Dazu wird eine Ansteueranordnung verwendet, die die übliche Ansteuerung um die Zusatzfunktion erweitert, den MOSFET nach dem Auftreten des Fehlerfalls einzuschalten, wenn die Bodydiode elektrisch leitend ist. Abgesehen davon bleiben die übliche Ansteuerung des MOSFET und das übliche Schutzkonzept von der Erfindung unberührt.

Ein erfindungsgemäßer Stromrichter, insbesondere ein Traktionsstromrichter, weist mehrere MOSFET, insbesondere mehrere jeweils auf einem Halbleiter mit breitem Bandabstand basierende MOSFET, und für jeden MOSFET eine erfindungsgemäße Ansteueranordnung zum Ansteuern des MOSFET auf. Die Erfindung eignet sich insbesondere für das Ansteuern eines MOSFET eines Traktionsstromrichters, da Strombelastungen eines MOSFET eines Traktionsstromrichters, insbesondere durch Rückwärtsströme, sehr hoch sein können und daher hohe Verluste verursachen können.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines MOSFET,
- FIG 2: einen Schaltplan eines MOSFET und eines ersten Ausführungsbeispiels einer Ansteueranordnung zum Ansteuern des MOSFET,
- FIG 3: ein Zusatzansteuersignal in Abhängigkeit von einer Drain-Source-Spannung eines MOSFET,
- FIG 4: einen Schaltplan eines Stromrichters,
- FIG 5: ein Ablaufdiagramm eines Verfahrens zum Ansteuern eines MOSFET.

Einander entsprechende Teile sind in den Figuren mit denselben Bezugszeichen versehen.

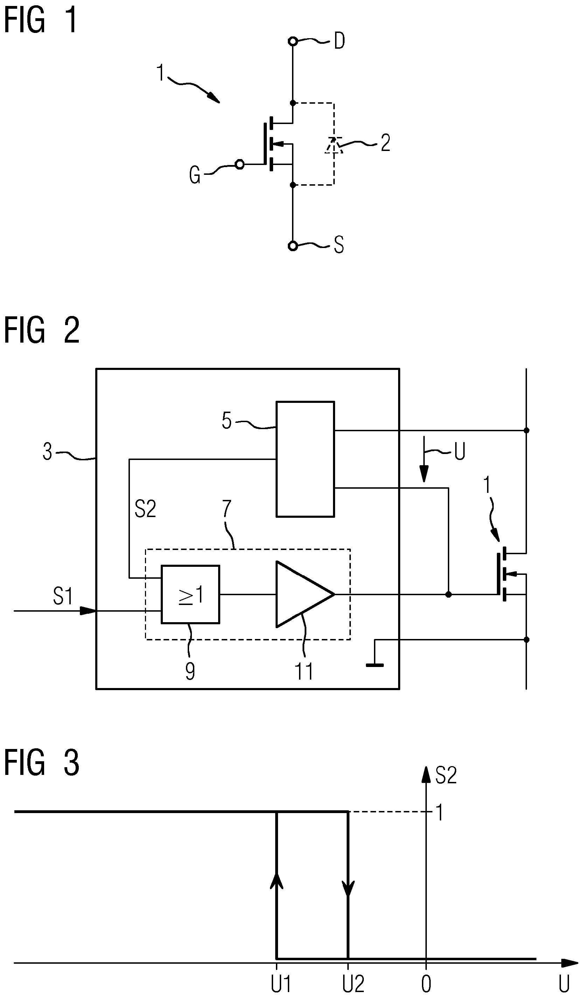

FIG 1 zeigt einen Schaltplan eines MOSFET 1 mit einem Drain-Anschluss D, einem Source-Anschluss S, einem Gate-Anschluss G und einer Bodydiode 2. Der MOSFET 1 ist als ein normal sperrender n-Kanal-MOSFET ausgebildet, der auf einem Halbleiter mit breitem Bandabstand, beispielsweise auf Siliciumcarbid oder Galliumnitrid, basiert. Rückwärtsströme, das heißt Ströme, die (gemäß technischer Stromrichtung) von dem Source-Anschluss S zu dem Drain-Anschluss D gerichtet sind, fließen im ausgeschalteten Zustand des MOSFET 1 durch die Bodydiode 2.

FIG 2 zeigt einen Schaltplan eines wie in FIG 1 ausgebildeten MOSFET 1 und eines ersten Ausführungsbeispiels einer erfindungsgemäßen Ansteueranordnung 3 zum Ansteuern des MOSFET 1.

Die Ansteueranordnung 3 umfasst eine Überwachungseinheit 5 und eine Steuereinheit 7. Die Überwachungseinheit 5 ist dazu ausgebildet, zu ermitteln, ob die Bodydiode 2 des MOSFET 1 elektrisch leitend oder sperrend ist, und dies der Steuereinheit 7 mitzuteilen. Dazu erfasst die Überwachungseinheit 5 eine Drain-Source-Spannung U zwischen dem Drain-Anschluss D und dem Source-Anschluss S des MOSFET 1 und gibt ein von der Drain-Source-Spannung U abhängiges binäres Zusatzansteuersignal S2 an die Steuereinheit 7 aus, das den Wert 0 oder den Wert 1 annimmt. Der Wert 1 des Zusatzansteuersignals S2 signalisiert, dass die Bodydiode 2 elektrisch leitend ist. Der Wert 0 des Zusatzansteuersignals S2 signalisiert, dass die Bodydiode 2 elektrisch sperrend ist.

FIG 3 zeigt das von der Überwachungseinheit 5 ausgegebene Zusatzansteuersignal S2 in Abhängigkeit von der Drain-Source-Spannung U. Das Zusatzansteuersignal S2 nimmt den Wert 1 an, wenn die Drain-Source-Spannung U einen vorgegebenen ersten Spannungs-Schwellenwert U1 unterschreitet. Das Zusatzansteuersignal S2 nimmt den Wert 0 an, wenn die Drain-Source-Spannung U einen vorgegebenen zweiten Spannungs-Schwellenwert U2 überschreitet. Beide Spannungs-Schwellenwerte U1, U2 sind negativ, wobei der zweite Spannungs-Schwellenwert U2 größer als der erste Spannungs-Schwellenwert U1 ist. Beispielsweise hat der erste Spannungs-Schwellenwert U1 einen Wert von etwa -1 V und der zweite Spannungs-Schwellenwert U2 hat einen Wert von etwa -0,5 V. Bei Werten der Drain-Source-Spannung U, die zwischen den beiden Spannungs-Schwellenwerten U1, U2 liegen, wird das Zusatzansteuersignal S2 nicht geändert, das heißt behält seinen momentanen Wert bei.

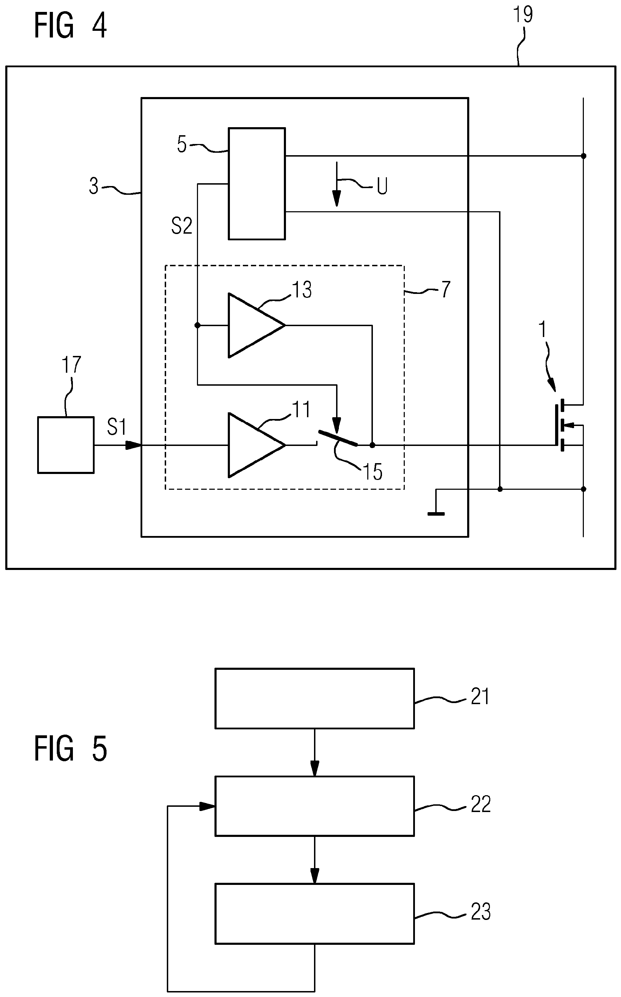

Der MOSFET 1 ist in einem Stromrichter 19 angeordnet, der mehrere MOSFET 1 aufweist (siehe dazu auch FIG 4). Die Steuereinheit 7 steuert den MOSFET 1 in Abhängigkeit von einem binären Ansteuersignal S1, das den Wert 0 oder den Wert 1 annimmt, und nach dem Auftreten eines Fehlerfalls, der zu einem Ausschalten aller MOSFET 1 des Stromrichters 19 geführt hat, zusätzlich in Abhängigkeit von dem Zusatzansteuersignal S2 an. Dazu weist die Steuereinheit 7 ein Oder-Gatter 9 und eine Endstufe 11 auf. Dem Oder-Gatter 9 werden das Ansteuersignal S1 und das Zusatzansteuersignal S2 zugeführt. Das Oder-Gatter 9 gibt den Wert 0 an die Endstufe 11 aus, wenn sowohl das Ansteuersignal S1 als auch das Zusatzansteuersignal S2 den Wert 0 annehmen. Andernfalls gibt das Oder-Gatter 9 den Wert 1 an die Endstufe 11 aus. Wenn das Oder-Gatter 9 den Wert 1 ausgibt, schaltet die Endstufe 11 den MOSFET 1 ein, indem sie eine positive Einschaltspannung zwischen den Gate-Anschluss G und den Source-Anschluss S des MOSFET 1 legt. Andernfalls schaltet die Endstufe 11 den MOSFET 1 aus, indem sie eine Ausschaltspannung zwischen den Gate-Anschluss G und den Source-Anschluss S des MOSFET 1 legt.

FIG 4 zeigt einen Schaltplan eines Stromrichters 19 mit einem MOSFET 1 und einem zweiten Ausführungsbeispiel einer erfindungsgemäßen Ansteueranordnung 3 zum Ansteuern des MOSFET 1. Der Stromrichter 19 ist beispielsweise ein Traktionsstromrichter mit weiteren (hier nicht dargestellten) MOSFET 1, die in bekannter Weise zu Halb- oder Vollbrücken verschaltet sind, und einer weiteren Ansteueranordnung 3 für jeden weiteren MOSFET 1.

Die Ansteueranordnungen 3 dieses Ausführungsbeispiels unterscheiden sich von dem in FIG 2 gezeigten Ausführungsbeispiel lediglich durch die Ausführung der Steuereinheiten 7. Eine Steuereinheit 7 dieses Ausführungsbeispiels weist zwei Endstufen 11, 13 und einen Schalter 15 auf. Einer ersten Endstufe 11 wird ein Ansteuersignal S1 zugeführt. Der zweiten Endstufe 13 wird nach dem Auftreten eines Fehlerfalls, der zu einem Ausschalten aller MOSFET 1 des Stromrichters 19 geführt hat, das von der Überwachungseinheit 5 der jeweiligen Ansteueranordnung 3 ausgegebene Zusatzansteuersignal S2 zugeführt. Der Schalter 15 trennt einen Ausgang der ersten Endstufe 11 von dem Gate-Anschluss G des von der Ansteueranordnung 3 angesteuerten MOSFET 1, wenn das Zusatzansteuersignal S2 den Wert 1 annimmt. In diesem Fall wird der MOSFET 1 von der zweiten Endstufe 13 eingeschaltet, indem die zweite Endstufe 13 eine positive Einschaltspannung zwischen den Gate-Anschluss G und den Source-Anschluss S des MOSFET 1 legt. Wenn das Zusatzansteuersignal S2 den Wert 0 annimmt, wird der Ausgang der ersten Endstufe 11 durch den Schalter 15 mit dem Gate-Anschluss G des von der Ansteueranordnung 3 angesteuerten MOSFET 1 verbunden und der MOSFET 1 wird durch die erste Endstufe 11 angesteuert, das heißt von der zweiten Endstufe 13 wird keine Spannung zwischen den Gate-Anschluss G und den Source-Anschluss S des MOSFET 1 gelegt und der MOSFET 1 wird von der ersten Endstufe 11 eingeschaltet, wenn das Ansteuersignal S1 den Wert 1 annimmt, und ausgeschaltet, wenn das Ansteuersignal S1 den Wert 0 annimmt.

Die Ansteuersignale S1 für die MOSFET 1 des Stromrichters 19 werden von einer Steuerung 17 des Stromrichters 19 erzeugt. Es kann vorgesehen sein, dass die Ansteuerung der MOSFET 1 in Abhängigkeit von den Zusatzansteuersignalen S2 durch die zweiten Endstufen 13 nur aktiviert wird, wenn die Steuerung 17 dazu eine Freigabe erteilt.

FIG 5 zeigt ein Ablaufdiagramm eines Ausführungsbeispiels des erfindungsgemäßen Verfahrens zum Ansteuern eines MOSFET 1 mit einer gemäß FIG 2 oder FIG 4 ausgeführten Ansteueranordnung 3.

In einem ersten Verfahrensschritt 21 werden die Spannungs-Schwellenwerte U1, U2 für die Drain-Source-Spannung U vorgegeben.

In einem zweiten Verfahrensschritt 22 werden von der Überwachungseinheit 5 die Drain-Source-Spannung U erfasst und das Zusatzansteuersignal S2 in Abhängigkeit von der Drain-Source-Spannung U in der oben anhand von FIG 3 beschriebenen Weise gebildet und an die Steuereinheit 7 ausgegeben.

In einem dritten Verfahrensschritt 23 wird der MOSFET 1 von der Steuereinheit 7 nach dem Auftreten eines Fehlerfalls, der zu einem Ausschalten aller MOSFET 1 des Stromrichters 19 geführt hat, eingeschaltet, das heißt es wird eine Einschaltspannung zwischen den Gate-Anschluss G und den Source-Anschluss S des MOSFET 1 gelegt, wenn das Zusatzansteuersignal S2 den Wert 1 annimmt. Andernfalls wird der MOSFET 1 von der Steuereinheit 7 in Abhängigkeit von dem Ansteuersignal S1 angesteuert, das heißt es wird die Einschaltspannung zwischen den Gate-Anschluss G und den Source-Anschluss S des MOSFET 1 gelegt, wenn das Ansteuersignal S1 den Wert 1 annimmt, oder eine Ausschaltspannung zwischen den Gate-Anschluss G und den Source-Anschluss S des MOSFET 1 gelegt, wenn das Ansteuersignal S1 den Wert 0 annimmt. Nach dem dritten Verfahrensschritt 23 wird das Verfahren mit dem zweiten Verfahrensschritt 22 fortgesetzt.

Die oben anhand der Figuren beschriebenen Ausführungsbeispiele einer erfindungsgemäßen Ansteueranordnung 3 und des erfindungsgemäßen Verfahrens können auf verschiedene Weisen zu alternativen Ausführungsbeispielen modifiziert werden. Insbesondere kann die Überwachungseinheit 5 in anderer Weise als in den oben anhand der Figuren beschriebenen Ausführungsbeispielen ausgebildet sein.

Beispielsweise kann die Überwachungseinheit 5 dazu ausgebildet sein, statt der Drain-Source-Spannung U eine Drain-Source-Stromstärke eines in einer Durchlassrichtung der Body-diode 2 zwischen dem Drain-Anschluss D und dem Source-Anschluss S fließenden Drain-Source-Stroms zu erfassen und auszuwerten. In diesem Fall werden ein erster Strom-Schwellenwert für die Drain-Source-Stromstärke und ein zweiter Strom-Schwellenwert für die Drain-Source-Stromstärke, der kleiner als der erste Strom-Schwellenwert ist, vorgegeben. Das Zusatzansteuersignal S2 wird auf den Wert 1 gesetzt, wenn die Drain-Source-Stromstärke den ersten Strom-Schwellenwert überschreitet. Das Zusatzansteuersignal S2 wird auf den Wert 0 gesetzt, wenn die Drain-Source-Stromstärke den ersten Strom-Schwellenwert unterschreitet. Bei Werten der Drain-Source-Stromstärke, die zwischen den beiden Strom-Schwellenwerten liegen, wird das Zusatzansteuersignal S2 nicht geändert, das heißt behält seinen momentanen Wert bei. Die Drain-Source-Stromstärke wird beispielsweise mit einem Shuntwiderstand gemessen, der in dem Strompfad des Drain-Source-Stroms angeordnet ist.

Alternativ kann die Überwachungseinheit 5 dazu ausgebildet sein, eine Richtung des Drain-Source-Stroms zu erfassen. In diesem Fall wird das Zusatzansteuersignal S2 auf den Wert 1 gesetzt, wenn der Drain-Source-Strom in der Durchlassrichtung der Bodydiode 2 fließt. Andernfalls wird das Zusatzansteuersignal S2 auf den Wert 0 gesetzt. Beispielsweise wird die Richtung des Drain-Source-Stroms unter Verwendung eines ferromagnetischen Kerns ermittelt, der bei jedem Richtungswechsel des Drain-Source-Stroms einen Spannungsimpuls auslöst. Die Richtung des Drain-Source-Stroms wird beispielsweise durch eine Zählung der ausgelösten Spannungsimpulse oder durch ein Flipflop, das bei jedem ausgelösten Spannungsimpuls seinen Zustand ändert, bestimmt.

Zu FIG 4 alternative Ausführungsbeispiele eines Stromrichters 19 ergeben sich durch Ersetzen der in FIG 4 gezeigten Ansteueranordnung 3 durch eine Ansteueranordnung 3 des in Figur 2 beschriebenen Ausführungsbeispiels oder eines der vorgenannten modifizierten Ausführungsbeispiele.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

## Patentansprüche

1. Verfahren zum Ansteuern eines MOSFET (1), insbesondere eines auf einem Halbleiter mit breitem Bandabstand basierenden MOSFET (1), eines mehrere MOSFET (1) aufweisenden Stromrichters (19), wobei nach dem Auftreten eines Fehlerfalls, der zu einem Ausschalten aller MOSFET (1) des Stromrichters (19) geführt hat,
- überwacht wird, ob die Bodydiode (2) des MOSFET (1) elektrisch leitend ist,
- der MOSFET (1) eingeschaltet wird, wenn die Bodydiode (2) elektrisch leitend ist, und
- der MOSFET (1) in Abhängigkeit von einem Ansteuersignal (S1) angesteuert wird, wenn die Bodydiode (2) elektrisch sperrend ist,
- wobei eine Drain-Source-Spannung (U) zwischen dem Drain-Anschluss (D) und dem Source-Anschluss (S) des MOSFET (1) erfasst wird,
**dadurch gekennzeichnet,**
- **dass** ein erster Spannungs-Schwellenwert (U1) für die Drain-Source-Spannung (U) vorgegeben wird und darauf geschlossen wird, dass die Bodydiode (2) elektrisch leitend ist, wenn die Drain-Source-Spannung (U) den ersten Spannungs-Schwellenwert (U1) unterschreitet,
- **dass** ein zweiter Spannungs-Schwellenwert (U2) für die Drain-Source-Spannung (U) vorgegeben wird und darauf geschlossen wird, dass die Bodydiode (2) elektrisch sperrend ist, wenn die Drain-Source-Spannung (U) den zweiten Spannungs-Schwellenwert (U2) überschreitet,
- **dass** die Richtung eines zwischen dem Drain-Anschluss (D) und dem Source-Anschluss (S) des MOSFET (1) fließenden Drain-Source-Stroms erfasst wird und darauf geschlossen wird, dass die Bodydiode (2) elektrisch leitend ist, wenn der Drain-Source-Strom in einer Durchlassrichtung der Body-diode (2) fließt,
- **dass** darauf geschlossen wird, dass die Bodydiode (2) elektrisch sperrend ist, wenn der Drain-Source-Strom entgegengesetzt zu der Durchlassrichtung der Bodydiode (2) fließt,
- **dass** in einem ersten Verfahrensschritt (21) die Spannungs-Schwellenwerte (U1, U2) für die Drain-Source-Spannung (U) vorgegeben werden, wobei in einem zweiten Verfahrensschritt (22) von einer Überwachungseinheit (5) die Drain-Source-Spannung (U) erfasst und ein Zusatzansteuersignal (S2) in Abhängigkeit von der Drain-Source-Spannung (U) gebildet und an eine Steuereinheit (7) ausgegeben werden und wobei in einem dritten Verfahrensschritt (23) der MOSFET (1) von der Steuereinheit (7) nach dem Auftreten eines Fehlerfalls, der zu einem Ausschalten aller MOSFET (1) des Stromrichters (19) geführt hat, eingeschaltet wird und
- **dass** eine Einschaltspannung zwischen den Gate-Anschluss (G) und den Source-Anschluss (S) des MOSFET (1) gelegt wird, wenn das Zusatzansteuersignal (S2) den Wert 1 annimmt, wobei der Wert 1 des Zusatzansteuersignals (S2) signalisiert, dass die Bodydiode (2) elektrisch leitend ist, und wobei der Wert 1 des Zusatzansteuersignals (S2) signalisiert, dass die Bodydiode (2) elektrisch leitend ist, und dass andernfalls der MOSFET (1) von der Steuereinheit (7) in Abhängigkeit von dem Ansteuersignal (S1) angesteuert wird, wobei die Einschaltspannung zwischen den Gate-Anschluss (G) und den Source-Anschluss (S) des MOSFET (1) gelegt wird, wenn das Ansteuersignal (S1) den Wert 1 annimmt, oder eine Ausschaltspannung zwischen den Gate-Anschluss (G) und den Source-Anschluss (S) des MOSFET (1) gelegt wird, wenn das Ansteuersignal (S1) den Wert 0 annimmt, wobei nach dem dritten Verfahrensschritt (23) das Verfahren mit dem zweiten Verfahrensschritt (22) fortgesetzt wird.

2. Verfahren nach Anspruch 1, wobei beide Spannungs-Schwellenwerte (Ul, U2) negativ sind, wobei der zweite Spannungs-Schwellenwert (U2) größer als der erste Spannungs-Schwellenwert (Ul) ist.

3. Verfahren nach einem der vorhergehenden Ansprüche, wobei ein erster Strom-Schwellenwert für eine Drain-Source-Stromstärke eines in einer Durchlassrichtung der Bodydiode (2) zwischen dem Drain-Anschluss (D) und dem Source-Anschluss (S) des MOSFET (1) fließenden Drain-Source-Stroms vorgegeben wird, die Drain-Source-Stromstärke erfasst wird und darauf geschlossen wird, dass die Bodydiode (2) elektrisch leitend ist, wenn die Drain-Source-Stromstärke den ersten Strom-Schwellenwert überschreitet.

4. Verfahren nach Anspruch 3, wobei ein zweiter Strom-Schwellenwert für die Drain-Source-Stromstärke, der kleiner als der erste Strom-Schwellenwert ist, vorgegeben wird und darauf geschlossen wird, dass die Bodydiode (2) elektrisch sperrend ist, wenn die Drain-Source-Stromstärke den zweiten Strom-Schwellenwert unterschreitet.

5. Ansteueranordnung (3), die dazu ausgebildet ist, das Verfahren nach einem der vorhergehenden Ansprüche durchzuführen, die Ansteueranordnung (3) umfassend
- eine Überwachungseinheit (5), die dazu ausgebildet ist, zu ermitteln, ob die Bodydiode (2) elektrisch leitend oder sperrend ist, und
- eine Steuereinheit (7), die dazu ausgebildet ist, nach dem Auftreten eines Fehlerfalls, der zu einem Ausschalten aller MOSFET (1) des Stromrichters (19) geführt hat, den MOSFET (1) einzuschalten, wenn die Überwachungseinheit (5) ermittelt, dass die Bodydiode (2) elektrisch leitend ist, und den MOSFET (1) in Abhängigkeit von dem Ansteuersignal (S1) anzusteuern, wenn die Bodydiode (2) elektrisch sperrend ist,
- wobei die Überwachungseinheit (5) dazu ausgebildet ist, die Drain-Source-Spannung (U) zu erfassen und anhand der Drain-Source-Spannung (U) zu ermitteln, ob die Bodydiode (2) elektrisch leitend oder sperrend ist,
- wobei die Überwachungseinheit (5) dazu ausgebildet ist, die Drain-Source-Stromstärke zu erfassen und anhand der Drain-Source-Stromstärke zu ermitteln, ob die Bodydiode (2) elektrisch leitend oder sperrend ist und
- wobei die Überwachungseinheit (5) dazu ausgebildet ist, die Richtung des Drain-Source-Stroms zu erfassen und anhand der Richtung des Drain-Source-Stroms zu ermitteln, ob die Body-diode (2) elektrisch leitend oder sperrend ist und
- wobei die Überwachungseinheit (5) dazu ausgebildet ist, der Steuereinheit (7) durch ein Zusatzansteuersignal (S2) mitzuteilen, ob die Bodydiode (2) elektrisch leitend oder sperrend ist, und wobei die Steuereinheit (7) eine Endstufe (11) zur Ansteuerung des MOSFET (1) in Abhängigkeit von dem Zusatzansteuersignal (S2) und dem Ansteuersignal (S1) aufweist oder wobei die Überwachungseinheit (5) dazu ausgebildet ist, der Steuereinheit (7) durch ein Zusatzansteuersignal (S2) mitzuteilen, ob die Bodydiode (2) elektrisch leitend oder sperrend ist, und wobei die Steuereinheit (7) eine erste Endstufe (11) zur Ansteuerung des MOSFET (1) in Abhängigkeit von dem Ansteuersignal (S1) im Fall, dass die Bodydiode (2) elektrisch sperrend ist, und eine zweite Endstufe (13) zur Ansteuerung des MOSFET (1) in Abhängigkeit von dem Zusatzansteuersignal (S2) im Fall, dass die Bodydiode (2) elektrisch leitend ist, aufweist.

6. Stromrichter (19) mit mehreren MOSFET (1), wobei der Stromrichter (19) für jeden MOSFET (1) eine gemäß einem der vorhergehenden Ansprüche ausgebildete Ansteueranordnung (3) zum Ansteuern des MOSFET (1) aufweist.

7. Stromrichter (19) nach Anspruch 6, wobei der Stromrichter (19) ein Traktionsstromrichter ist.

## Claims

1. Method for actuating a MOSFET (1), in particular a MOSFET (1) based on a semiconductor with a wide bandgap, a converter (19) having a number of MOSFETs (1), wherein after the occurrence of a fault, which has resulted in all MOSFETs (1) of the converter (19) switching off,
- it is monitored whether the body diode (2) of the MOSFET (1) is electrically conducting,
- the MOSFET (1) is switched on if the body diode (2) is electrically conducting, and
- the MOSFET (1) is actuated as a function of an actuation signal (S1) if the body diode (2) is electrically conducting,
- wherein a drain-source voltage (U) is detected between the drain terminal (D) and the source terminal (S) of the MOSFET (1),
**characterised in that**
- a first voltage threshold value (U1) is predetermined for the drain-source voltage (U) and it is concluded therefrom that the body diode (2) is electrically conducting when the drain-source voltage (U) fails to reach the first voltage threshold value (U1),
- a second voltage threshold value (U2) is predetermined for the drain-source voltage (U) and it is concluded therefrom that the body diode (2) is electrically blocking when the drain-source voltage (U) exceeds the second voltage threshold value (U2),
- the direction of a drain-source current flowing between the drain terminal (D) and the source terminal (S) of the MOSFET (1) is detected and it is concluded therefrom that the body diode (2) is electrically conducting when the drain-source current flows in a forward direction of the body diode (2),
- it is concluded therefrom that the body diode (2) is electrically blocking when the drain-source current flows opposite to the forward direction of the body diode (2),
- in a first method step (21) the voltage threshold values (U1, U2) are predetermined for the drain-source voltage (U), wherein in a second method step (22) a monitoring unit (5) detects the drain-source voltage (U) and forms an additional actuation signal (S2) as a function of the drain-source voltage (U) and outputs the same to a control unit (7) and wherein in a third method step (23), the MOSFET (1) is switched on by the control unit (7) after the occurrence of a fault, which has resulted in all MOSFETs (1) of the converter (19) switching off, and
- a switch-on voltage is applied between the gate terminal (G) and the source terminal (S) of the MOSFET (1) when the additional actuation signal (S2) assumes the value 1, wherein the value 1 of the additional actuation signal (S2) signals that the body diode (2) is electrically conducting and wherein the value 1 of the additional actuation signal (S2) signals that the body diode (2) is electrically conducting, and otherwise, the MOSFET (1) is actuated by the control unit (7) as a function of the actuation signal (S1), wherein the switch-on voltage is applied between the gate terminal (G) and the source terminal (S) of the MOSFET (1) when the actuation signal (S1) assumes the value 1, or a switch-off voltage is applied between the gate terminal (G) and the source terminal (S) of the MOSFET (1) when the actuation signal (S1) assumes the value 0, wherein after the third method step (23), the method is continued with the second method step (22).

2. Method according to claim 1, wherein both voltage threshold values (U1, U2) are negative, wherein the second voltage threshold value (U2) is greater than the first voltage threshold value (U1).

3. Method according to one of the preceding claims, wherein a first current threshold value is predetermined for a drain-source current intensity of a drain-source current flowing in a forward direction of the body diode (2) between the drain terminal (D) and the source terminal (S) of the MOSFET (1), the drain-source current intensity is detected and it is concluded therefrom that the body diode (2) is electrically conducting if the drain-source current intensity exceeds the first voltage threshold value.

4. Method according to claim 3, wherein a second current threshold value is predetermined for the drain-source current intensity, which is smaller than the first current threshold value, and it is concluded therefrom that the body diode (2) is electrically blocking if the drain-source current intensity does not reach the second current threshold value.

5. Actuation arrangement (3) which is embodied to carry out the method according to one of the preceding claims, the actuation arrangement (3) comprising
- a monitoring unit (5), which is embodied to determine whether the body diode (2) is electrically conducting or blocking, and
- a control unit (7), which is embodied, after the occurrence of a fault, which has resulted in all MOSFETs (1) of the converter (19) switching off, to switch on the MOSFET (1) if the monitoring unit (5) determines that the body diode (2) is electrically conducting, and to actuate the MOSFET (1) as a function of the actuation signal (S1) if the body diode (2) is electrically blocking,
- wherein the monitoring unit (5) is embodied to detect the drain-source voltage (U) and to determine on the basis of the drain-source voltage (U) whether the body diode (2) is electrically conducting or blocking,
- wherein the monitoring unit (5) is embodied to detect the drain-source current intensity and on the basis of the drain-source current intensity to determine whether the body diode (2) is electrically conducting or blocking and
- wherein the monitoring unit (5) is embodied to detect the direction of the drain-source current and on the basis of the direction of the drain-source current to determine whether the body diode (2) is electrically conducting or blocking, and
- wherein the monitoring unit (5) is embodied to communicate to the control unit (7) by means of an additional actuation signal (S2) whether the body diode (2) is electrically conducting or blocking, and wherein the control unit (7) has an end stage (11) for actuating the MOSFET (1) as a function of the additional actuation signal (S2) and the actuation signal (S1)) or wherein the monitoring unit (5) is embodied to communicate to the control until (7) by means of an additional actuation signal (S2) whether the body diode (2) is electrically conducting or blocking, and wherein the control unit (7) has a first end stage (11) for actuating the MOSFET (1) as a function of the actuation signal (S1) in the event that the body diode (2) is electrically blocking, and a second end stage (13) for actuating the MOSFET (1) as a function of the additional actuation signal (S2) in the event that the body diode (2) is electrically conducting.

6. Converter (19) with a number of MOSFETs (1), wherein the converter (19) for each MOSFET (1) has an actuation arrangement (3), embodied according to one of the preceding claims, for actuating the MOSFET (1).

7. Converter (19) according to claim 6, wherein the converter (19) is a traction converter.

## Revendications

1. Procédé de commande d'un MOSFET (1), en particulier d'un MOSFET (1) à base d'un semiconducteur, à grand intervalle d'énergie entre deux bandes, d'un convertisseur (19) de puissance ayant plusieurs MOSFET (1), dans lequel, après l'apparition d'un cas de défaillance, qui a conduit à un blocage de tous les MOSFET (1) du convertisseur (19) de puissance,
- on contrôle, si la diode (2) de corps du MOSFET (1) est conductrice de l'électricité,
- on met le MOSFET (1) à l'état passant, si la diode (2) de corps est conductrice d'électricité, et
- on commande le MOFSET (1) en fonction d'un signal (S1) de commande, si la diode (2) de corps est bloquante électriquement,
- dans lequel on détecte une tension (U) de drain-source entre la borne (D) de drain et la borne (S) de source du MOSFET (1),
**caractérisé**
- **en ce que** l'on prescrit une première valeur (U1) de seuil de tension pour la tension (U) de drain-source et on déduit que la diode (2) de corps est conductrice de l'électricité, si la tension (U) de drain-source est inférieure à la première valeur (U1) de seuil de tension,
- **en ce que** l'on prescrit une deuxième valeur (U2) de seuil de tension pour la tension (U) de drain-source et on déduit que la diode (2) de corps est bloquante électriquement, si la tension (U) de drain-source dépasse la deuxième valeur (U2) de seuil de tension,
- **en ce que** l'on détecte le sens d'un courant de drain-source passant entre la borne (D) de drain et la borne (S) de source du MOSFET (1) et on déduit que la diode (2) de corps est conductrice de l'électricité, si le courant de drain-source passe dans un sens passant de la diode (2) de corps,
- **en ce que** l'on déduit que la diode (2) de corps est bloquante électriquement, si le courant de drain-source passe dans le sens contraire au sens passant de la diode (2) de corps,
- **en ce que** dans un premier stade (21) du procédé, on prescrit les valeurs (U1, U2) de seuil de tension pour la tension (U) de drain-source, dans lequel dans un deuxième stade (22) du procédé on détecte par une unité (5) de contrôle la tension (U) de drain-source et on forme un signal (S2) de commande supplémentaire en fonction de la tension (U) de drain-source et on l'envoie à une unité (7) de commande et dans lequel, dans un troisième stade (23) du procédé, on met le MOSFET (1) à l'état passant par l'unité (7) de commande après l'apparition d'un cas de défaillance, qui a conduit à un blocage de tous les MOSFET (1) du convertisseur (19) de puissance et
- **en ce que** l'on applique une tension de mise à l'état passant entre la borne (G) de grille et la borne (S) de source du MOSFET (1), si le signal (S2) de commande supplémentaire prend la valeur 1, dans lequel la valeur 1 du signal (S2) de commande supplémentaire signale que la diode (2) de corps est conductrice électriquement, et dans lequel la valeur 1 du signal (S2) de commande supplémentaire signale que la diode (2) de corps est conductrice de l'électricité et en ce que sinon on commande le MOSFET (1) par l'unité (7) de commande en fonction du signal (S1) de commande, dans lequel on applique la tension de mise à l'état passant entre la borne (G) de grille et la borne (S) de source du MOSFET (1), si le signal (S1) de commande prend la valeur 1, ou on applique une tension de blocage entre la borne (G) de grille et la borne (S) de source du MOSFET (1), si le signal (S1) de commande prend la valeur 0, dans lequel après le troisième stade (23) du procédé, on continue le procédé par le deuxième stade (22) du procédé.

2. Procédé suivant la revendication 1, dans lequel les deux valeurs (U1, U2) de seuil de tension sont négatives, dans lequel la deuxième valeur (U2) de seuil de tension est plus grande que la première valeur (U1) de seuil de tension.

3. Procédé suivant l'une des revendications précédentes, dans lequel on prescrit une première valeur de seuil de courant pour une intensité du courant de drain-source d'un courant de drain-source passant dans un sens passant de la diode (2) de corps entre la borne (D) de drain et la borne (S) de source du MOSFET (1), on détecte l'intensité du courant de drain-source et on en déduit que la diode (2) de corps est conductrice de l'électricité, si l'intensité du courant de drain-source dépasse la première valeur de seuil du courant.

4. Procédé suivant la revendication 3, dans lequel on prescrit une deuxième valeur de seuil du courant pour une intensité du courant de drain-source, qui est plus petite que la première valeur de seuil du courant et on déduit que la diode (2) de corps est bloquante électriquement, si l'intensité de drain-source est inférieure à la deuxième valeur de seuil du courant.

5. Agencement (3) de commande, qui est constitué pour exécuter le procédé suivant l'une des revendications précédentes, l'agencement (3) de commande comprenant :
- une unité (5) de contrôle, qui est constituée pour déterminer, si la diode (2) de corps est conductrice ou bloquante de l'électricité, et
- une unité (7) de commande, qui est constituée pour, après l'apparition d'un cas de défaillance, qui a conduit à un blocage de tous les MOSFET (1) du convertisseur (19) de puissance, mettre le MOSFET (1) à l'état passant, si l'unité (5) de contrôle détermine que la diode (2) de corps est conductrice de l'électricité et commander le MOSFET (1) en fonction du signal (S1) de commande, si la diode (2) de corps est bloquante de l'électricité,
- dans lequel l'unité (5) de contrôle est constituée pour détecter la tension (U) de drain-source et pour, à l'aide de la tension (U) de drain-source, déterminer, si la diode (2) de corps est conductrice ou bloquante de l'électricité,
- dans lequel l'unité (5) de contrôle est constituée pour détecter l'intensité du courant de drain-source et pour, à l'aide de l'intensité du courant de drain-source, déterminer si la diode (2) de corps est conductrice ou bloquante de l'électricité et
- dans lequel l'unité (5) de contrôle est constituée pour détecter le sens du courant de drain-source et pour, à l'aide du sens du courant de drain-source, déterminer si la diode (2) de corps est conductrice ou bloquante de l'électricité et
- dans lequel l'unité (5) de contrôle est constituée pour indiquer à l'unité (7) de commande par un signal (S2) de commande supplémentaire, si la diode (2) de corps est conductrice ou bloquante de l'électricité, et dans lequel l'unité (7) de commande a un étage (11) final de commande du MOSFET (1) en fonction du signal (S2) de commande supplémentaire et du signal (S1) de commande où dans lequel l'unité (5) de contrôle est constituée pour indiquer à l'unité (7) de commande par un signal (S2) de commande supplémentaire, si la diode (2) de corps est passante ou bloquante de l'électricité, et dans lequel l'unité (7) de commande a un premier étage (11) final de commande du MOSFET (1) en fonction du signal (S1) de commande, dans le cas où la diode (2) de corps est bloquante de l'électricité et un deuxième étage (13) final de commande du MOSFET (1) en fonction du signal (S2) de commande supplémentaire, dans le cas où la diode (2) de corps est passante de l'électricité.

6. Convertisseur (19) de puissance ayant plusieurs MOSFET (1), dans lequel le convertisseur (19) de puissance a pour chaque MOSFET (1) un agencement (3) de commande du MOSFET (1) pour situer suivant l'une des revendications précédentes.

7. Convertisseur (19) de puissance suivant la revendication 6, dans lequel le convertisseur (19) de puissance est un convertisseur de puissance de traction.
